(19) Europäisches Patentamt
European Patent Office
Office européen des brevets

(11) EP 2 266 203 B1

(12) FASCICULE DE BREVET EUROPEEN

(45) Date de publication et mention de la délivrance du brevet:
**23.05.2012 Bulletin 2012/21**

(21) Numéro de dépôt: **09745954.9**

(22) Date de dépôt: **16.04.2009**

(51) Int Cl.:
*H03F 1/02* (2006.01)    *H03F 3/60* (2006.01)
*H03H 15/00* (2006.01)    *H04B 1/00* (2006.01)
*H04B 1/04* (2006.01)

(86) Numéro de dépôt international:
**PCT/FR2009/050711**

(87) Numéro de publication internationale:
**WO 2009/138635 (19.11.2009 Gazette 2009/47)**

(54) **Circuit integré et procédé de traitement d'un signal numérique multinorme à radiofréquence**

Integrierter Schaltkreis und entsprechendes Verfahren zur Verarbeitung eines digitalen Mehrtyp-Funkfrequenzsignals

Integrated circuit and corresponding method of processing a multitype radio frequency digital signal

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **18.04.2008 FR 0852655**

(43) Date de publication de la demande:
**29.12.2010 Bulletin 2010/52**

(73) Titulaire: **STMicroelectronics SA**
**92120 Montrouge (FR)**

(72) Inventeurs:
• **CATHELIN, Andreia**
**F-38190 Laval (FR)**
• **FLAMENT, Axel**
**F-59700 Marcq En Baroeul (FR)**
• **KAISER, Andreas**
**F-59650 Villeneuve D'ascq (FR)**

(74) Mandataire: **Zapalowicz, Francis**
**Casalonga & Partners**
**Bayerstrasse 71/73**
**80335 München (DE)**

(56) Documents cités:
• **FRAPPE' A.: "All-digital RF signal generation using Delta-Sigma modulation for mobile communication terminals" [Online] 7 décembre 2007 (2007-12-07), UNIVERSITE DES SCIENCES ET TECHNOLOGIES DEL LILLE , LILLE , XP002508612 Extrait de l'Internet: URL:http: //tel.archives-ouvertes.fr/docs/0 0/28/09/68/PDF/AFR_These_final.pdf> [extrait le 2008-12-16] alinéa [2.1.2] alinéa [2.2.1] alinéa [4.5.2] page 130, alinéa 1**
• **FRAPPE A ET AL: "Design techniques for very high speed digital delta-sigma modulators aimed at all-digital RE transmitters" ELECTRONICS, CIRCUITS AND SYSTEMS, 2006. ICECS '06. 13TH IEEE INTERNAT IONAL CONFERENCE ON, IEEE, PI, 1 décembre 2006 (2006-12-01), pages 1113-1116, XP031111689 ISBN: 978-1-4244-0394-3**
• **NSIALA NZEZA C ET AL: "Reconfigurable digital Delta-Sigma Modulator Synthesis for digital wireless transmitters" CIRCUIT THEORY AND DESIGN, 2007. ECCTD 2007. 18TH EUROPEAN CONFERENCE ON, IEEE, PISCATAWAY, NJ, USA, 27 août 2007 (2007-08-27), pages 480-483, XP031257788 ISBN: 978-1-4244-1341-6**

**EP 2 266 203 B1**

**Description**

L'invention concerne le traitement de signaux numériques, notamment radiofréquences, et en particulier la conversion numérique-analogique de tels signaux ainsi que leur amplification de puissance.

L'invention s'applique avantageusement mais non limitativement au domaine de la communication sans fil, en particulier la téléphonie mobile.

Les technologies CMOS actuelles utilisent des tensions d'alimentation de plus en plus faibles. Par ailleurs, il existe pour certaines applications, une nécessité d'effectuer une conversion numérique analogique d'un signal numérique et d'obtenir *in fine* un signal analogique de forte puissance.

Il existe donc un besoin de pouvoir générer un signal analogique de puissance relativement élevée à partir d'un signal numérique traité par une technologie, par exemple CMOS, dont la tension d'alimentation est faible, par exemple 1 volt.

C'est le cas notamment pour la téléphonie mobile où la puissance d'émission du signal doit satisfaire à des valeurs spécifiées en fonction de la norme utilisée.

Par ailleurs, la téléphonie mobile compte à elle seule de nombreuses normes de deuxième génération telles que le GSM et DCS 1800 en Europe, ainsi que l'IS-95 aux Etats-Unis. Il existe également trois normes de troisième génération, à savoir l'UMTS européen, le CDMA 2000 américain, et le TD-SCDMA chinois. Par ailleurs, deux normes intermédiaires entre celle de deuxième génération et celle de troisième génération existent, à savoir le GPRS et la norme Edge.

Les terminaux mobiles sont en outre de plus en plus nombreux à intégrer la technologie Bluetooth (ieee 802.15.1) permettant des communications courte portée, ainsi que la technologie Wi-Fi (ieee 802.11) permettant d'accéder aux réseaux locaux sans fil (WLAN).

La réalisation d'un terminal, tel qu'un téléphone mobile, compatible avec ces différents standards, nécessite aujourd'hui la réalisation de plusieurs puces radiofréquence différentes.

Aussi, est-il envisagé à l'heure actuelle d'utiliser des circuits capables de s'adapter à plusieurs normes de transmission tout en gardant la même infrastructure matérielle.

Pour tenter d'atteindre cet objectif, des solutions consistent à augmenter le volume de la partie numérique de la chaîne de transmission par rapport à celui de la partie analogique qui est plus difficilement reconfigurable.

Ainsi, une première solution qui a été envisagée, consiste à traiter la partie « bande de base » et « fréquence intermédiaire » de la chaîne de transmission de manière numérique. Cette approche va dans le sens d'une certaine flexibilité du système.

Par ailleurs, les avancées des technologies CMOS submicroniques permettent à présent d'atteindre des fréquences de travail élevées. Aussi, des solutions, jusqu'alors théoriques, ont envisagé une numérisation plus importante de la chaîne de transmission, incorporant notamment des traitements numériques de transposition de fréquence pour atteindre le domaine des radiofréquences.

Le document FRAPPE' A.: "All-digital RF signal génération using Delta-Sigma modulation for mobile communication terminals", 7 décembre 2007, UNIVERSITE DES SCIENCES ET TECHNOLOGIES DEL LILLE, LILLE, Extrait de l'Internet: URL:http://tel.archives-ouvertes.fr/docs/00/28/09/68/PDF/ AFR_These_final.pdf décrit un circuit intégré pour la génération numérique de signaux RF pour les terminaux de communication mobile par modulation $\Delta\Sigma$. Dans le paragraphe 4.5.2 on cite que le mélangeur numérique est suivi d'une amplification/ conversion AD sur 1 - bit en utilisant la technique des inverseurs progressifs. A la page 130, on cite la possibilité de réaliser la chaîne de combinaison de puissance à l'aide de lignes de transmission pour remplacer les étages traditionnels d'amplification de puissance.

Il existe donc actuellement un besoin, dans le contexte de développement d'une « radio logicielle » (ou SDR : Software Defined Radio »), c'est-à-dire une radio reconfigurable, de conserver une flexibilité au niveau de l'interface numérique/analogique et de l'amplificateur de puissance.

Selon un mode de réalisation et de mise en oeuvre, il est proposé un dispositif et un procédé qui permettent d'apporter une puissance nécessaire tout en utilisant de faibles tensions d'alimentation.

Selon un mode de mise en oeuvre et de réalisation, il est également proposé un dispositif électronique et un procédé de traitement d'un signal numérique radiofréquence permettant une flexibilité au niveau de la puissance générée, de façon à pouvoir s'adapter à différentes normes de transmission.

Il est également proposé, selon un mode de mise en oeuvre et de réalisation, un dispositif électronique et un procédé de traitement incorporant un filtrage numérique qui puisse être éventuellement reconfigurable pour pouvoir s'adapter à différentes normes de transmission.

Selon un aspect il est proposé un circuit intégré, incorporant un dispositif électronique comprenant des moyens d'entrée pour recevoir un signal numérique radiofréquence, des moyens de sortie aptes à délivrer un signal analogique radiofréquence et un étage de traitement couplé entre les moyens d'entrée et les moyens de sortie. Cet étage de traitement comporte plusieurs (au moins deux) voies de traitement en parallèle. Chaque voie de traitement inclut un bloc de commutation de tension dont l'entrée est couplée aux moyens d'entrée, et une ligne de transmission sensiblement du type quart d'onde à la fréquence du signal analogique radiofréquence, couplée en série entre la sortie du bloc de commutation de tension et lesdits moyens de sortie.

Le dispositif électronique selon cet aspect, est remarquable en ce sens qu'il remplit la double fonction de conversion numérique/analogique et d'amplification de puissance. En effet, les blocs de commutation de tension assurent notamment la conversion numérique/analogique, et la sommation analogique des signaux délivrés par les blocs de commutation de tension, au travers des lignes de transmission, permet une recombinaison de puissance et par conséquent une augmentation du gain en puissance. En particulier, une configuration spéciale des blocs de commutation de tension et de l'impédance caractéristique de la ligne de transmission permet d'obtenir un gain en puissance proportionnel au carré du nombre de voies de traitement utilisées. Il est ainsi possible d'obtenir une puissance relativement élevée avec une tension d'alimentation relativement faible de la partie commutation de tension.

Par ailleurs, dans le cas d'un bloc de commutation de tension, le signal à traiter est généralement un signal de type carré dans lequel on peut récupérer une partie de l'information spectrale, ce qui nécessite l'emploi d'un filtre constitué par exemple d'un assemblage LC série, qui présente une impédance théoriquement nulle à la fréquence d'accord et idéalement infinie en dehors de sa bande passante. De ce fait, la puissance fournie par l'alimentation ne contient que l'information utile. L'utilisation de tels blocs de commutation de tension est donc préférable à l'utilisation de blocs de commutation en courant, pour lesquels le filtre sélectif est généralement configuré dans un assemblage LC parallèle qui présente une impédance théoriquement infinie à la fréquence d'accord et idéalement nulle en dehors de sa bande passante, ce qui a pour conséquence que la puissance fournie par l'alimentation contient non seulement la puissance utile mais également la puissance hors bande.

Par ailleurs, outre le fait qu'une recombinaison de puissance à partir de lignes de transmission permette de générer la puissance nécessaire pour la transmission du signal à partir de faibles tensions d'alimentation, les lignes de transmission sont des éléments sélectifs en fréquence, permettant ainsi d'assurer une première fonction de filtrage en sortie des blocs de commutation de tension, ce qui permet en particulier un premier filtrage du bruit de quantification des signaux radiofréquence, ce qui est particulièrement intéressant dans le cas d'un signal radiofréquence issu d'un modulateur de type delta-sigma.

Par ailleurs, une technologie à haut facteur de qualité permet d'intégrer efficacement les lignes de transmission, en diminuant de manière importante les pertes de ces éléments.

Les lignes de transmission peuvent être avantageusement individuellement sélectionnables. La puissance délivrée est alors variable en fonction du nombre des voies de traitement effectivement sélectionnées. Ceci est particulièrement intéressant dans des applications multinormes où les puissances d'émission spécifiées peuvent être différentes.

En particulier lorsque le circuit intégré est incorporé dans une chaîne de transmission d'un terminal sans fil, il est nécessaire de filtrer le signal avant de l'émettre, dans un souci de répondre aux spécifications imposées par l'emploi de la norme de communication correspondante. Ceci est plus particulièrement vrai lorsque l'on utilise une modulation delta-sigma en amont de la conversion numérique/analogique, qui met en forme le bruit de quantification pour le pousser en dehors de la bande utile, ce qui a pour conséquence d'augmenter drastiquement les contraintes de filtrage au sein des systèmes employant cette technique.

Dans ces conditions, selon un mode de réalisation, l'étage de traitement comporte en outre un étage de filtrage qui est partiellement couplé entre les moyens d'entrée et les blocs de commutation de tension, et partiellement formé par certaines au moins des voies de traitement. En d'autres termes, l'architecture du circuit intégré utilisant des voies de traitement permet d'utiliser ces voies de traitement dans la réalisation de l'étage de filtrage, ce qui permet de combiner au moins partiellement la fonction de filtrage avec la double fonction de conversion numérique/analogique et d'amplification de puissance, tout en réduisant la surface du circuit intégré.

En effet, le fait que les voies de traitement soient connectées en parallèle et effectuent par conséquent une sommation de signaux analogiques, permet de réaliser cette fonction de sommation nécessaire dans le cadre de la réalisation d'un filtrage.

Par ailleurs, dans un mode particulier de réalisation, le nombre et les valeurs des coefficients du filtre dépendent du nombre de voies de traitement effectivement sélectionnées.

La partie de l'étage de filtrage qui est couplée entre les moyens d'entrée et les blocs de commutation de tension comporte par exemple des moyens de retard numériques, ce qui permet en particulier de déterminer et d'ajuster l'ordre du filtre réalisé par l'étage de filtrage.

Lorsque l'étage de filtrage comporte des moyens de retard numériques, le filtre est alors semi-numérique en raison de la sommation analogique faite au niveau des lignes de transmission. Cela étant on parlera néanmoins dans ce cas de filtre « numérique » par abus de langage en raison notamment de la prise en compte d'un signal d'horloge dans la définition des retards.

Mais la partie de l'étage de filtrage située en amont des blocs de commutation de tension pourrait être également analogique (retards réalisés par exemple par des composants analogiques tels que des lignes de transmission). En effet lorsque le signal en amont des blocs de commutation de tension est un signal numérique dont les niveaux logiques sont matérialisés par des niveaux discrets de tension différents, il est bien entendu possible d'effectuer un traitement analogique de filtrage sur ces niveaux de tensions.

L'étage de filtrage numérique est avantageusement un étage de filtrage numérique du type à réponse impulsionnelle finie (FIR : Finite Impulse Response).

L'utilisation d'un filtre du type FIR est avantageuse car un tel filtre est inconditionnellement stable et sa réponse en phase peut être parfaitement linéaire si nécessaire, ce qui est le cas si les coefficients du filtre sont choisis de façon à être symétriques.

De façon à pouvoir filtrer le signal avec un filtre compatible avec des spécifications de plusieurs normes de transmission, il est particulièrement avantageux que l'étage de filtrage, par exemple numérique, soit reconfigurable, en particulier qu'il puisse être reconfiguré sur commande parmi un jeu prédéterminé de filtres différents caractérisés par des coefficients et/ou des ordres différents.

A cet égard, une solution peut consister à prévoir un étage de multiplexage commandable couplé entre les moyens de retard numériques de l'étage de filtrage et les blocs de commutation de tension.

Une autre solution, qui n'est d'ailleurs pas incompatible avec la précédente, peut consister à prévoir des moyens de retard numériques présentant des valeurs de retard ajustables.

Une solution pour réaliser un bloc de commutation de tension, prévoit l'utilisation d'un inverseur CMOS. Cela étant, selon l'application envisagée, et en particulier selon l'impédance de l'antenne de transmission d'une chaîne de transmission, et selon la valeur de la tension d'alimentation utilisée, il peut être préférable d'utiliser dans chaque bloc de commutation de tension, une chaîne d'inverseurs de tailles croissantes.

Par ailleurs, il est avantageux que le dispositif électronique présente une architecture différentielle. En effet, une telle structure différentielle permet notamment de symétriser les fronts et ainsi de s'affranchir du problème d'interférence entre symboles.

Selon un mode de réalisation, le circuit intégré comprend en outre un modulateur delta-sigma couplé à un mélangeur numérique apte à délivrer ledit signal numérique radiofréquence. En effet, un modulateur delta-sigma est particulièrement avantageux, dans le cas d'applications de communication sans fil où les spécifications en bande sont drastiques, car le modulateur delta-sigma permet de quantifier un signal suréchantillonné sur n bit, en un signal sur N bit, par exemple 1 bit, N étant d'une façon générale inférieur à n.

Selon un autre aspect, il est également proposé une chaîne d'émission d'un signal radiofréquence comprenant un circuit intégré tel que défini ci-avant, couplé à une antenne d'émission.

Selon un autre aspect, il est encore proposé un élément d'un système de communication sans fil, par exemple un téléphone mobile cellulaire, incorporant une telle chaîne d'émission.

Selon un autre aspect, il est encore proposé un procédé de traitement d'un signal numérique radiofréquence initial, comprenant :

- une conversion numérique/analogique avec amplification de puissance comportant plusieurs traitements de commutation en tension effectués en parallèle sur un signal numérique radiofréquence intermédiaire issu du signal initial, et délivrant respectivement des signaux analogiques élémentaires, et
- une sommation des signaux analogiques élémentaires au travers de plusieurs lignes de transmission, ces lignes de transmission pouvant être individuellement sélectionnables, de façon à délivrer un signal analogique radiofréquence dont la puissance est supérieure à celle du signal numérique initial, les lignes de transmission étant sensiblement du type quart d'onde à la fréquence du signal analogique radiofréquence.

Selon un mode de mise en oeuvre, le procédé comprend en outre un filtrage, en particulier numérique, du signal initial délivrant le signal intermédiaire, ce filtrage utilisant partiellement les voies de traitement effectivement sélectionnées.

Selon un mode de mise en oeuvre, on ajuste l'ordre du filtrage en retardant de façon ajustable certains échantillons du signal initial en amont des traitements de commutation en tension.

On peut également reconfigurer le filtrage.

Selon un autre aspect, il est encore proposé un procédé de transmission d'un signal analogique radiofréquence comprenant un traitement numérique de modulation du type delta-sigma effectué sur un signal numérique en bande de base, une transposition numérique de fréquence effectuée sur le signal numérique modulé, et un procédé de traitement tel que défini ci-avant, effectué sur le signal numérique radiofréquence initial issu de la transposition de fréquence.

D'autres avantages et caractéristiques de l'invention apparaîtront à l'examen de la description détaillée de modes de mise en oeuvre et de réalisation, nullement limitatifs, et des dessins annexés sur lesquels :

- la figure 1 illustre de façon schématique un mode de réalisation d'une chaîne de transmission d'un téléphone mobile cellulaire selon l'invention ;
- la figure 2 illustre plus en détail mais toujours de façon schématique un exemple de réalisation d'un dispositif électronique selon l'invention ;

- la figure 3 illustre plus en détail et toujours de façon schématique un exemple de réalisation d'un bloc de commutation de tension ;
- la figure 4 illustre un autre mode de réalisation d'un bloc de commutation de tension ;
- la figure 5 illustre un autre mode de réalisation d'un dispositif électronique selon l'invention incorporant un filtre numérique ;
- la figure 6 illustre de façon schématique un autre mode de réalisation d'un dispositif électronique selon l'invention illustrant une autre implémentation possible d'un filtre numérique ;
- la figure 7 illustre de façon schématique une architecture différentielle d'un exemple de dispositif électronique selon l'invention ; et
- les figures 8 et 9 illustrent des réponses fréquentielles de différents filtres numériques réalisées au sein d'un dispositif selon l'invention.

Bien que l'invention ne soit pas limitée à cette application, on va maintenant décrire plus en détail des exemples de mise en oeuvre et de réalisation de l'invention plus particulièrement applicables dans le domaine de la téléphonie mobile.

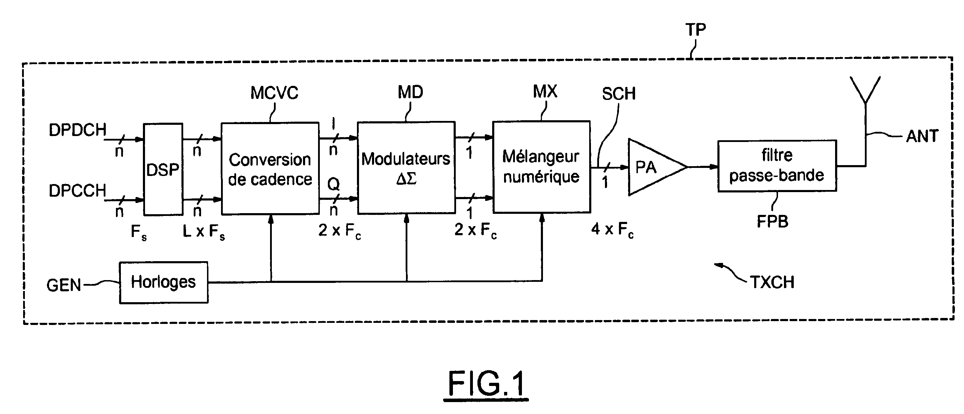

Sur la figure 1, la référence TP désigne un élément d'un système de communication sans fil, par exemple un terminal tel qu'un téléphone mobile et la référence TXCH désigne la chaîne de transmission incorporée dans ce téléphone mobile.

Cette chaîne de transmission TXCH comporte un processeur de traitement de signal DSP recevant des informations contenues dans les signaux d'entrée DPDCH (Dedicated Physical Data Channels) et DPCCH (Dedicated Physical Control Channels) et apte à effectuer les opérations classiques de codage de canal. Dans l'exemple d'applications décrit ici, Fs désigne le débit des symboles ou fragments (« Chip », selon une dénomination anglosaxonne bien connue de l'homme du métier) et Fc est la fréquence centrale de la bande de transmission de la norme de transmission considérée.

Au sein du processeur DSP, les signaux sont étalés sur une bande d'environ 5 MHz, qui est la largeur d'un canal UMTS, et échantillonnés à deux fois le débit fragment, soit 7,68 MHz (3,84 x 2).

Par ailleurs, la chaîne d'émission doit pouvoir placer ce signal de 5 MHz sur l'un des douze canaux possibles, puisque la bande passante d'émission et de réception dans le cadre de la norme UMTS est de 60 MHz. Ceci est effectué de façon classique grâce à des filtres demi-bande et à un algorithme de CORDIC (Coordinate Rotation Digital Computing). Ces filtres demi-bande suréchantillonnent le signal par 16 afin d'obtenir une fréquence d'échantillonnage de 122,88 MHz, c'est-à-dire 32 fois la fréquence Fs. Ceci permet de rejeter l'image en dehors de la bande utile qui s'étale de -30 MHz à +30 MHz.

La chaîne d'émission TXCH comporte par ailleurs un étage de modulation du type delta-sigma, référencé MD. Dans l'architecture considérée, l'entrée de l'étage de modulation MD doit être échantillonnée à deux fois la fréquence centrale de la norme UMTS, soit 3,9 Giga symboles/seconde (deux fois 1,95 GHz). Or, puisque le processeur DSP qui effectue le traitement en bande de base, délivre des signaux échantillonnés à 122,88 MHz, il est nécessaire d'effectuer une conversion de cadence pour passer d'un échantillonnage à un autre. C'est le rôle des moyens de conversion de cadence MCVC.

L'étage de modulation delta-sigma MD permet de quantifier le signal suréchantillonné sur n bit présent en son entrée en un signal sur N bit, N étant inférieur à n. Dans le cas présent, N est égal à 1. Cette opération s'effectue sans dégrader le signal en bande utile tout en émettant le bruit de quantification en dehors de cette même bande, ce qui est très appréciable dans le cas de communication mobile où les spécifications en bande sont drastiques.

Toute architecture connue de modulateur delta sigma peut être utilisée, en particulier celle à quantification non exacte décrite dans la demande de brevet français n° 0752701

Le signal radiofréquence délivré par le modulateur delta-sigma est un signal en bande de base (spectre fréquentiel du signal centré sensiblement sur la fréquence nulle) sur un bit cadencé à une fréquence d'échantillonnage égale à 2 fois Fc, soit 3,9 Giga symboles/seconde pour l'UMTS ou bien 3,495 Giga symboles/seconde pour la norme DCS. Le bruit de quantification, généré par le passage du signal de n bit vers 1, est mis en forme en dehors de la bande utile.

Le signal numérique délivré par l'étage de modulation delta-sigma est un signal en bande de base qu'il convient de transposer dans le domaine radiofréquence. C'est le rôle du mélangeur numérique MX qui est de structure classique et connu en soi. A titre indicatif, afin d'effectuer la transposition numérique en radiofréquence de deux signaux numériques d'entrée, une façon classique consiste à générer un sinus et un cosinus numériques à la fréquence Fc. A cet égard, d'après le théorème de Shannon, un échantillonnage à 4Fc du sinus et du cosinus est suffisant pour retranscrire correctement ces signaux. On obtient alors une suite [1 ; 0 ;-1 ;0] pour le cosinus et [0 ; 1 ; 0 ; -1] pour le sinus, chaque bit ayant une durée de 1/4Fc.

Les séquences I (voie en phase) et Q (voie en quadrature de phase), qui sont des séquences de symboles multibits dans le cas général, sont alors pondérées par ces motifs puis additionnées. Ainsi, à chaque période d'horloge, un des arguments est nul, l'autre prenant la valeur du signal I ou Q multiplié par +1 ou -1. Cette opération peut être aisément réalisée avec des portes logiques « OU exclusif » ou des portes de transmission.

Le signal issu du mélangeur numérique MX est dans le cas présent un signal numérique sur un bit échantillonné à la fréquence 4Fc.

Outre les éléments qui viennent d'être décrits, un générateur de signaux d'horloge GEN fournit les différents signaux d'horloge aux différents moyens de la chaîne de traitement numérique.

Le signal radiofréquence codé sur 1 bit, issu du mélangeur numérique MX, occupe une bande de fréquence proche de la fréquence centrale de la bande de communication envisagée, et est échantillonnée à quatre fois cette fréquence centrale Fc.

Dans le cas de la norme UMTS, la fréquence centrale de la bande de communication (contenant les différents canaux de communication)est égale à 1,95 GHz. Elle est égale à 1,7475 GHz pour la norme DCS.

Le signal SCH radiofréquence à haute cadence, généré à ce niveau de la chaîne d'émission, va maintenant subir une opération de conversion du domaine numérique vers le domaine analogique, combinée à une amplification de puissance afin de pouvoir être émis via l'antenne ANT après passage dans un filtre passe-bande FPB.

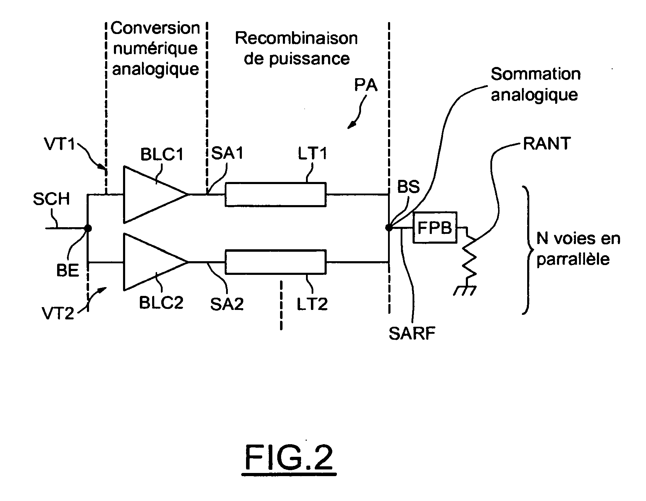

Cette opération combinée de conversion numérique/analogique et d'amplification de puissance est réalisée dans un dispositif PA dont on va maintenant décrire plus en détail des exemples de structures en se référant aux figures 2 et suivantes. Ces exemples de structures sont décrites pour un signal SCH sur 1 bit. Bien entendu l'homme du métier saura adapter ces exemples pour des signaux échantillonnés sur un nombre de bits supérieur à un.

Sur la figure 2, on voit que le dispositif PA comporte N voies de traitement parallèles VT1, VT2, ....

N est supérieur ou égal à 2.

Chaque voie de traitement, VT1 par exemple, comporte un bloc de commutation de tension BLC1 dont l'entrée est couplée à l'entrée BE du dispositif PA, et dont la sortie est couplée à une ligne de transmission LT1 dont la sortie est couplée à la borne de sortie BS du dispositif PA. Cette borne de sortie est par ailleurs couplée à l'antenne ANT dont on a représenté sur la figure 2 l'impédance RANT.

Chaque bloc de commutation de tension réalise une conversion numérique/analogique du signal numérique reçu à son entrée et délivre un signal analogique élémentaire correspondant, SA1 par exemple. Toutes les voies de traitement étant connectées en parallèle, l'ensemble des lignes de transmission $LT_i$ réalisent une sommation analogique de ces signaux analogiques élémentaires avec une augmentation de puissance. Et, dans un cas particulier de configuration des blocs de commutation de tension et de l'impédance caractéristique de la ligne de transmission, le gain en puissance du signal analogique SARF délivré à la sortie BS du dispositif PA est égal à $N^2$ où N désigne les voies de traitement effectivement utilisées. Plus précisément ce gain maximal égal à $N^2$ est atteint lorsque l'impédance caractéristique Z0 de la ligne de transmission tend vers l'infini ou lorsque l'impédance de sortie des blocs de commutation de tension est négligeable devant $Z0^2$ /NRL, où RL désigne l'impédance de la charge (par exemple l'antenne) connectée aux lignes de transmission. L'homme du métier saura ajuster la valeur de Z0 compte tenu du compromis recherché entre rendement et augmentation de puissance.

Outre son impédance caractéristique, chaque ligne de transmission a une longueur, exprimée en fraction d'une longueur d'onde. Dans l'application envisagée, la longueur de la ligne de transmission est égale à $\lambda/4$ à la fréquence Fc, où $\lambda$ désigne la longueur d'onde. Cette ligne de transmission est donc une ligne de transmission du type quart d'onde.

Une telle ligne de transmission est connue en soi par l'homme du métier. Elle peut être réalisée par des composants passifs selon une technique dite d'éléments localisés ou bien à partir simplement d'une ligne métallique selon une autre technique dite d'éléments distribués.

Lorsque la ligne de transmission est réalisée à partir d'une ligne métallique, sa longueur est choisie par exemple en fonction de la fréquence centrale de la bande de transmission en conformité avec la norme de transmission envisagée. Bien entendu une tolérance sur cette longueur est possible. En outre même si la longueur d'onde est définie par rapport à la fréquence centrale (1,95GHz pour l'UMTS) de la bande de transmission (largeur de la bande égale à 60 MHz pour l'UMTS), la ligne de transmission ne sera pas rigoureusement quart d'onde si le signal à émettre se situe dans un canal situé à l'extrémité de cette bande de transmission. Cependant ceci n'est pas gênant compte tenu du fait qu'une telle ligne de transmission a une bande passante relativement large, par exemple de l'ordre de 15%.

Cette caractéristique de largeur de bande passante d'une ligne de transmission est également intéressante à un autre égard. En effet une ligne de transmission choisie pour une première norme de transmission donnée conviendra aussi pour une deuxième norme de transmission dont la fréquence centrale est par exemple à $\pm$ 15% de celle de la première norme. C'est le cas par exemple pour les normes UMTS et DCS en émission.

Compte tenu de ce qui précède, on dira que la ligne de transmission est sensiblement du type quart d'onde à la fréquence du signal analogique à émettre.

Cela étant, il est également possible de prévoir différents jeux de lignes de transmission sensiblement du type quart d'onde à différentes fréquences, ces jeux étant sélectionnables.

Si les lignes de transmission sont réalisées à partir de composants inductifs et capacitifs, il est possible de prévoir par exemple des capacités commutées permettant de satisfaire au type sensiblement quart d'onde de la ligne de transmission pour différentes fréquences.

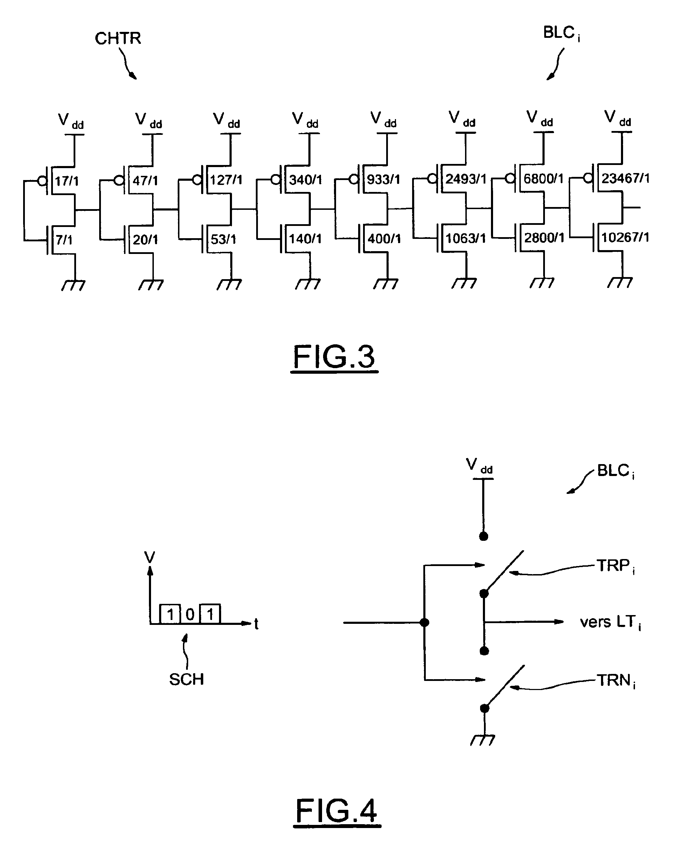

Une façon particulièrement simple de réaliser un bloc de commutation de tension BLCi est d'utiliser un inverseur CMOS comme illustré schématiquement sur la figure 3.

Cet inverseur CMOS comporte un transistor PMOS référencé TRPi dont la source est reliée à la tension d'alimentation Vdd et un transistor NMOS référencé TRNi, dont la source est reliée à la masse. Les drains de ces deux transistors sont connectés à la ligne de transmission LTi.

Les grilles des deux transistors de l'inverseur CMOS sont commandées par le signal SCH qui, dans l'exemple décrit ici, est un signal carré dont les niveaux hauts sont représentatifs par exemple d'un « 1 » logique, et dont les niveaux bas sont représentatifs d'un « 0 » logique.

Par ailleurs, la largeur W du canal de chaque transistor est de préférence bien supérieure à la longueur L de ce canal, de façon à minimiser la résistance de la zone triode du transistor.

Dans certaines applications où la tension d'alimentation Vdd est particulièrement faible, par exemple de l'ordre de 1 volt, il peut être nécessaire, comme illustré sur la figure 4, d'utiliser pour la réalisation du bloc de commutation BLCi une chaîne CHTR d'inverseurs CMOS de tailles croissantes. Ceci permettra de pouvoir en particulier piloter aisément une charge de 50 ohms représentative de l'impédance typique RANT d'une antenne, sous 1 volt. Sur la figure 4, à titre d'exemple non limitatif, le rapport W/L est indiqué pour chacun des transistors de chacun des inverseurs CMOS.

En fonctionnement, la tension de référence Vdd est divisée en différents niveaux par l'intermédiaire d'un réseau résistif comportant notamment l'impédance de l'antenne RANT ainsi que la résistance de la ligne de transmission. Dans le cas présent, chaque ligne de transmission forme un filtre LC qui présente une impédance théoriquement nulle à la fréquence d'accord et idéalement infinie en dehors de sa bande passante. Ainsi, la puissance fournie par l'alimentation ne contient que l'information utile, ce qui n'est pas le cas par exemple dans une commutation en courant.

La structure illustrée sur la figure 2 permet, comme il a été expliqué ci-avant, d'obtenir un signal analogique radiofréquence ayant une puissance suffisante, et ce même sous une faible tension d'alimentation, grâce à la recombinaison de puissance obtenue par la sommation analogique au travers des lignes de transmission connectées en parallèle. Cela étant, dans le but d'assurer une flexibilité en terme de puissance désirée, il est particulièrement avantageux que les lignes de transmission soient individuellement sélectionnables. On peut ainsi régler, en fonction du nombre de voies de transmission que l'on va effectivement sélectionner, la puissance désirée en sortie.

A titre indicatif, une façon particulièrement simple d'isoler une voie de transmission, c'est-à-dire de ne pas la sélectionner, consiste à rendre constamment passant le transistor TRNi de l'inverseur CMOS (figure 4).

Il est particulièrement intéressant, dans certaines applications, en particulier dans une application de téléphonie mobile, que le dispositif PA comprenne en outre un étage de filtrage numérique. En effet, le signal issu de l'étage de modulation delta-sigma contient beaucoup de bruit en dehors de la bande utile du signal. Aussi, l'étage de filtrage numérique allège les contraintes sur le filtrage analogique passe bande d'antenne. De plus, la proximité de bandes interdites oblige le concepteur à limiter les émissions hors bande de manière importante. Par exemple, la bande de réception de la norme DCS 1800 s'étale de 1805 à 1880 MHz et celle de la transmission dans le cas de la norme UMTS, de 1920 à 1980 MHz, soit un écart de 40 MHz entre les deux extrêmes des bandes. Par ailleurs, l'utilisation d'un multiplexage fréquentiel à transmission simultanée dans le cas de la norme UMTS interdit les émissions parasites dans la bande de réception correspondante (située à 130 MHz au dessus de la bande d'émission). L'utilisation d'un filtre numérique va ainsi permettre d'atténuer certaines bandes de fréquence du signal émis de façon à ne pas perturber d'autres bandes de fréquence relatives par exemple à la réception du signal, ou à d'autres normes de transmission.

On pourra utiliser de préférence un filtrage de type FIR (Finite Impulse Response) qui est un filtre inconditionnellement stable.

L'architecture du dispositif PA à base de lignes de transmission en parallèle, permet la réalisation matérielle de façon simple d'un tel filtre qui comme on va le voir dans la suite est un filtre semi-numérique ou « numérique » par abus de langage.

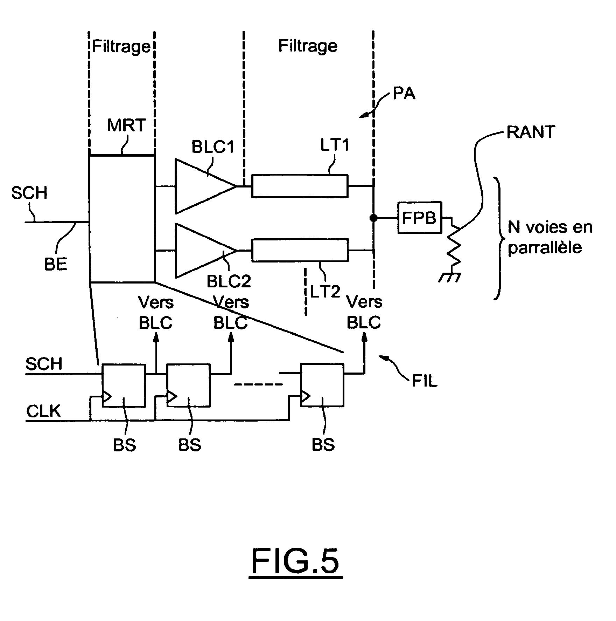

En effet, comme illustré schématiquement sur la figure 5, un tel étage de filtrage FIL peut être réalisé en disposant entre les moyens d'entrée BE et l'entrée des blocs de commutation de tension, des moyens de retard numériques MRT. Ces moyens de retard numériques peuvent être, comme illustré sur la figure 5, une ligne à retard formée d'une chaîne de bascules BS, cadencée par le signal d'horloge CLK dont la fréquence est égale à 4 fois Fc dans l'exemple décrit. Par ailleurs, le signal numérique radiofréquence SCH est délivré en entrée de la chaîne de bascules.

Le nombre de bascules est totalement indépendant du nombre de lignes de transmission. La profondeur de la ligne à retard contribue à la détermination de l'ordre du filtre.

Par ailleurs, le nombre de voies de traitement effectivement sélectionnées ou mises en oeuvre, conditionne le nombre de coefficients du filtre.

En d'autres termes, le choix des coefficients est limité par le nombre de voies utilisées. Ainsi, dans l'exemple d'architecture décrit, les coefficients ne pourront être que des coefficients entiers. Par exemple, pour réaliser le coefficient « 2 » on somme deux voies. L'obtention de coefficients négatifs est possible avec l'utilisation d'une architecture différentielle.

Par ailleurs, la somme des valeurs absolues des coefficients est inférieure ou égale au nombre de voies.

Cela étant, on peut augmenter l'ordre du filtre en insérant des « 0 » dans sa réponse impulsionnelle. Ainsi, même avec un nombre limité de coefficients, il est possible d'obtenir des filtres ayant une bande de transition étroite et répondant par conséquent à des spécifications d'un filtre d'ordre supérieur.

Il est particulièrement intéressant, dans le cadre par exemple d'une application de téléphonie mobile multi-normes, que le filtre numérique FIL soit reconfigurable, de façon à pouvoir satisfaire aux spécifications de plusieurs normes de transmission différentes.

Une solution pour reconfigurer le filtre numérique FIL peut consister à réaliser matériellement un étage de filtrage de façon à ce qu'en réponse à un signal de sélection, on sélectionne une configuration matérielle particulière entre les moyens de retard et les voies de traitement, parmi plusieurs configurations matérielles « précâblées » représentatives de filtres numériques de caractéristiques différentes.

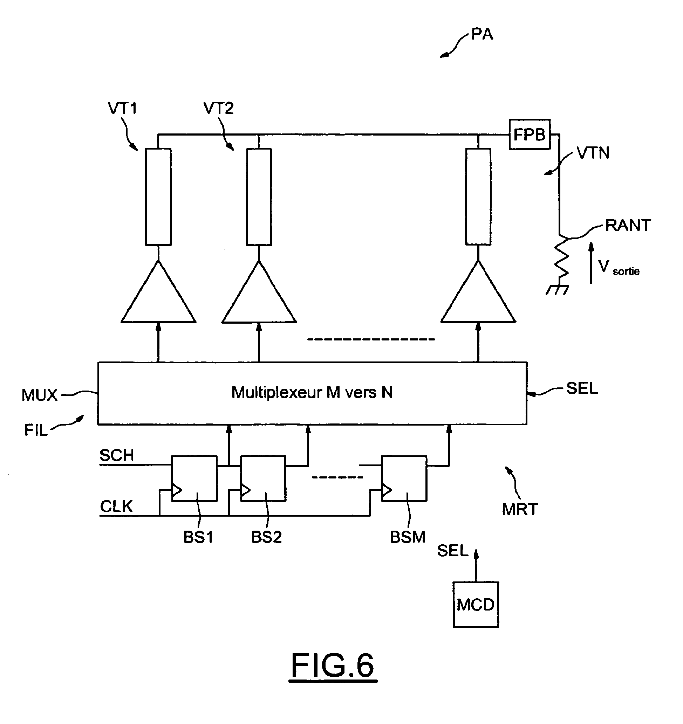

A cet égard, une solution pour réaliser un filtre reconfigurable peut prévoir, comme illustré sur la figure 6, de connecter un étage de multiplexage MUX entre les différentes voies de traitement et les moyens de retard numériques, en l'espèce les différentes bascules BS1-BSM de la chaîne de bascules.

Dans l'exemple illustré sur la figure 6, l'étage de multiplexage est un étage de multiplexage de M vers N puisque le nombre de bascules des moyens de retard numériques est égal à M et que le nombre de voies de traitement est égal à N.

Ainsi, selon la commande SEL du multiplexeur MUX, certaines au moins des bascules seront reliées à certaines au moins des voies de traitement, réalisant une configuration particulière de filtrage. Le signal de commande SEL est généré par des moyens de commande MCD, réalisés par exemple de façon logicielle au sein du processeur de la chaîne de traitement.

Une autre solution pour reconfigurer un filtre numérique peut consister à modifier la fréquence du signal d'horloge CLK.

Une autre solution peut prévoir l'utilisation d'une ligne à verrouillage de retard (DLL : Delay Locked Loop) de structure classique et connue par l'homme du métier, et à partir de laquelle pourront être générés des signaux d'horloge de fréquences différentes, destinés à cadencer certaines au moins des bascules des moyens de retard. Une telle solution présente l'avantage de pouvoir réaliser des retards non nécessairement multiples de la période du signal d'horloge CLK.

Il convient également de noter que toutes ces solutions peuvent être également combinées.

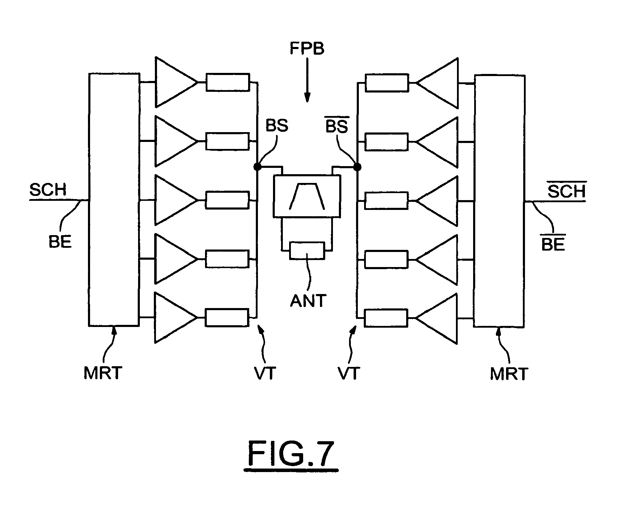

Alors que tous les modes de réalisation évoqués ci-dessus ont été présentés dans le cadre d'une architecture à entrée unique (Single Ended), il va de soi qu'ils peuvent également s'appliquer à une architecture différentielle comme celle illustrée schématiquement sur la figure 7.

Avec une telle architecture différentielle, le dispositif PA présente deux entrées $BE$ et $\overline{BE}$, recevant respecti-vement les signaux $SCH$ et $\overline{SCH}$. Il comporte également une sortie différentielle constituée des bornes $BS$ et $\overline{BS}$ qui sont reliées à l'antenne ANT via le filtre passe bande FPB.

Une telle architecture différentielle permet notamment la réalisation de coefficients négatifs pour le filtre numérique en prélevant les échantillons sur la voie $\overline{SCH}$.

A partir d'un exemple d'architecture du type de celle illustrée sur la figure 7, comportant cinq voies de traitement VT, une chaîne de 56 bascules BS et un étage de multiplexage, il est possible de reconfigurer le filtre numérique parmi trois configurations différentes.

Les cinq voies de traitement étant utilisées, pour tirer profit du maximum de gain en puissance possible, il y a par conséquent cinq coefficients b0, b1, b2, b3 et b4 pour chacun des filtres. Si l'on se limite aux filtres numériques FIR présentant des coefficients et des retards symétriques, la réponse impulsionnelle d'un tel filtre numérique est alors donnée par la formule suivante :

$$H(\omega) = b_0 + b_1 z^{-\alpha} + b_2 z^{-(\alpha+\beta)} + b_1 z^{-(\alpha+2\beta)} + b_0 z^{-(2\alpha+2\beta)} \qquad \textbf{(I)}$$

Pour tirer profit du maximum de gain en puissance possible, les cinq voies de traitement sont utilisées, ce qui se traduit pour les valeurs des coefficients par la formule suivante :

$$2|b_0| + 2|b_1| + |b_2| = 5 \qquad \qquad \textbf{(II)}$$

Parmi les différentes possibilités pour l'ensemble de ces coefficients, trois jeux ont été sélectionnés pour implémenter trois filtres FIR possibles. Les valeurs des différents retards $\alpha$ et $\beta$ ainsi que la valeur des coefficients et la position des zéros de transmission sont données dans le tableau ci-dessous :

| Retards $\alpha$ et $\beta$ (multiples de Te) | $\{b_0, b_1, b_2\}$ | Périodicité de la réponse fréquentielle | Fonction de transfert | Position des zéros |
|---|---|---|---|---|
| $\alpha=8$ et $\beta=8$ | $\{1, 1, 1\}$ | $F_e/8$ | $H_1(z)$ | $F_e/20$, $F_e/40$ |
| $\alpha=16$ et $\beta=8$ | $\{1, 1, 1\}$ | $F_e/8$ | $H_2(z)$ | $F_e/20$, $F_e/40$, $F_e/48$ |
| $\alpha=14$ et $\beta=14$ | $\{1,-1, 1\}$ | $F_e/14$ | $H_3(z)$ | $F_e/140$, $3F_e/140$ |

Les fonctions de transfert de ces trois filtres s'écrivent donc pour chacun des jeux de coefficients, avec une fréquence d'échantillonnage Fe égale à 7,8 GHz par les formules suivantes :

$$H_1(z) = 1 + z^{-8} + z^{-16} + z^{-24} + z^{-32}$$
$$H_2(z) = 1 + z^{-16} + z^{-24} + z^{-32} + z^{-48} \quad\quad (III)$$
$$H_3(z) = 1 - z^{-14} + z^{-28} - z^{-42} + z^{-56}$$

Les filtres numériques ainsi envisagés sont respectivement d'ordre 32, 48 et 56.

La commande de l'étage de multiplexage MUX va permettre de se placer dans l'une des trois configurations matérielles correspondant à chacun des trois filtres envisagés.

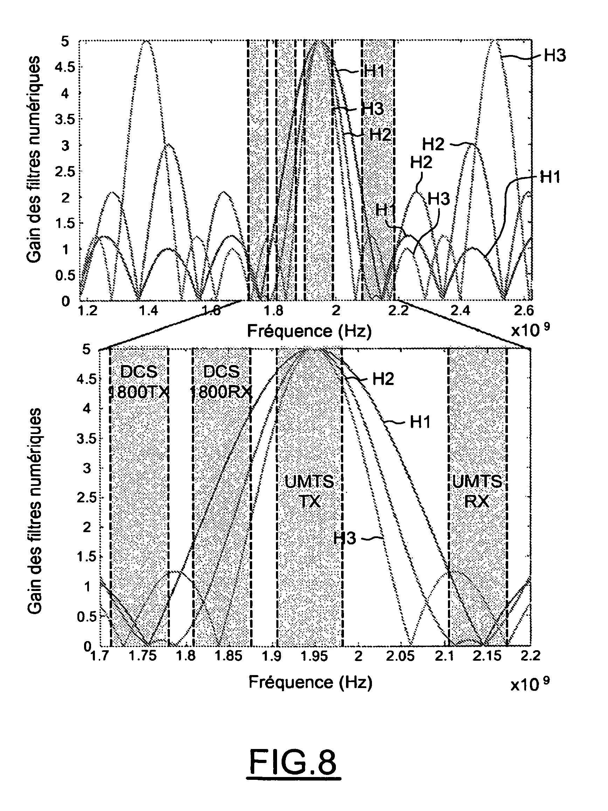

Les réponses fréquentielles de ces filtres sont représentées sur la figure 8.

Ainsi, la fonction de transfert $H_1$ permet de placer un zéro de transmission dans la bande de réception UMTS et un dans la bande de transmission DCS. La fonction $H_2$ permet de placer un zéro de transmission dans chacune des bandes d'émission et de réception DCS, et la fonction $H_3$ permet de placer deux zéros de transmission, l'un dans la bande de réception UMTS et un autre dans la bande de transmission DCS. La présence de deux zéros proches dans la réponse fréquentielle de ce filtre permet une forte atténuation dans les bandes proches de l'UMTS.

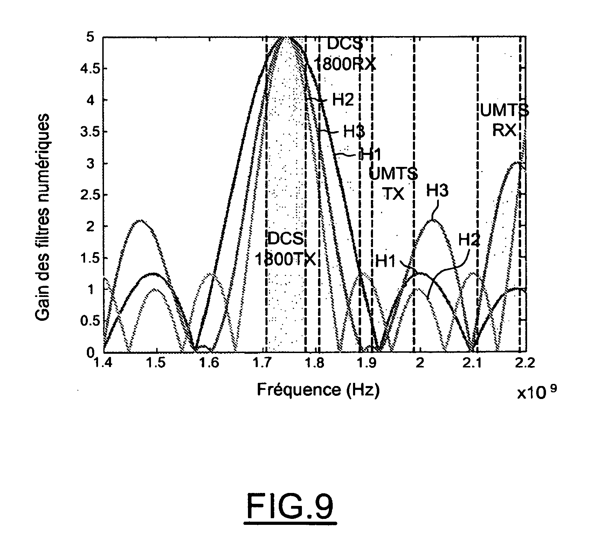

Il est en outre possible d'avoir une reconfigurabilité plus importante encore en changeant uniquement la fréquence d'échantillonnage. En effet, dans le cas de la norme DCS 1800, la fréquence à laquelle sont cadencées les données est de 6,99 GHz (4 x 1,7475 GHz). En gardant les trois mêmes jeux de coefficients que précédemment et en changeant uniquement la fréquence d'échantillonnage, on obtient les fonctions de transfert de la figure 9.

Il convient également de noter que l'architecture qui vient d'être décrite n'est pas incompatible avec l'adjonction en aval du dispositif PA d'au moins un autre étage d'amplification de structure classique. En effet il peut être possible en fonction de l'application envisagée d'amplifier le signal jusqu'à un certain niveau de puissance en utilisant un dispositif PA qui vient d'être décrit puis d'augmenter encore ce niveau de puissance en utilisant une solution classique d'amplification de puissance.

**Revendications**

1. Circuit intégré, incorporant un dispositif électronique (PA), comprenant des moyens d'entrée (BE) pour recevoir un signal numérique (SCH) radiofréquence, des moyens de sortie (BS) aptes à délivrer un signal analogique radiofréquence (SARF), et un étage de traitement couplé entre les moyens d'entrée et les moyens de sortie et comportant plusieurs voies de traitement (VTi) en parallèle, chaque voie de traitement (VTi) incluant un bloc de commutation de tension (BLCi) dont l'entrée est couplée aux moyens d'entrée et une ligne de transmission (LTi) sensiblement du type quart d'onde à la fréquence du signal analogique radiofréquence couplée en série entre la sortie du bloc de commutation de tension et lesdits moyens de sortie, **caractérisé en ce que** l'étage de traitement comporte en outre un étage de filtrage (FIL) reconfigurable, partiellement couplé entre les moyens d'entrée et les blocs de commutation de tension, partiellement formé par certaines au moins des voies de traitement, l'étage de filtrage (FIL) comportant des moyens de retard numériques (MRT) aptes à être couplés entre les moyens d'entrée et l'un au moins des blocs de commutation de tension, et un étage de multiplexage (MUX) commandable couplé entre les moyens de retard et les blocs de commutation de tension.

2. Circuit intégré selon la revendication 1, dans lequel les voies de traitement (VTi) sont individuellement sélectionnables.

3. Circuit intégré selon la revendication 2, dans lequel le nombre et les valeurs des coefficients du filtre (FIL) dépendent du nombre de voies de traitement effectivement sélectionnées.

4. Circuit intégré selon l'une des revendications précédentes, dans lequel l'étage de filtrage est un étage de filtrage numérique.

5. Circuit intégré selon la revendication 4, dans lequel l'étage de filtrage numérique (FIL) est un étage de filtrage numérique du type à réponse impulsionnelle finie.

6. Circuit intégré selon l'une des revendications précédentes, dans lequel les moyens de retard numériques (MRT) présentent des valeurs de retard ajustables.

7. Circuit intégré selon l'une des revendications précédentes, dans lequel chaque bloc de commutation de tension comporte une chaîne d'inverseurs de tailles croissantes (CHTR).

8. Circuit intégré selon l'une des revendications précédentes, dans lequel le dispositif électronique (PA) présente une architecture différentielle.

9. Circuit intégré selon l'une des revendications précédentes, dans lequel les voies de traitement comportent plusieurs jeux différents de lignes de transmission (LTi) sélectionnables, les lignes de transmission des différents jeux étant respectivement sensiblement du type quart d'onde à des fréquences différentes.

10. Circuit intégré selon l'une des revendications précédentes, comportant en outre un modulateur delta-sigma (MD) couplé à un mélangeur numérique (MX) apte à délivrer ledit signal numérique radiofréquence.

11. Chaîne d'émission d'un signal radiofréquence comprenant un circuit intégré selon l'une des revendications précédentes.

12. Elément d'un système de communication sans fil, par exemple un téléphone mobile cellulaire, incorporant une chaîne d'émission selon la revendication 11.


**Claims**

1. Integrated circuit, incorporating an electronic device (PA), comprising input means (BE) for receiving a radiofrequency digital signal (SCH), output means (BS) able to deliver a radiofrequency analogue signal (SARF), and a processing stage coupled between the input means and the output means and comprising several parallel processing pathways (VTi), each processing pathway (VTi) including a voltage switching block (BLCi) whose input is coupled to the input means and a transmission line (LTi), substantially of the quarter-wave type at the frequency of the radiofrequency analogue signal, coupled in series between the output of the voltage switching block and the said output means, **characterized in that** the processing stage furthermore comprises a reconfigurable filtering stage (FIL), partially coupled between the input means and the voltage switching blocks and partially formed by at least some of the processing pathways, the filtering stage (FIL) comprising digital delay means (MRT) able to be coupled between the input means and at least one of the voltage switching blocks, and a controllable multiplexing stage (MUX) coupled between the delay means and the voltage switching blocks.

2. Integrated circuit according to Claim 1, in which the processing pathways (VTi) are individually selectable.

3. Integrated circuit according to Claim 2, in which the number and the values of the coefficients of the filter (FIL) depend on the number of processing pathways that are actually selected.

4. Integrated circuit according to one of the preceding claims, in which the filtering stage is a digital filtering stage.

5. Integrated circuit according to Claim 4, in which the digital filtering stage (FIL) is a digital filtering stage of the finite impulse response type.

6. Integrated circuit according to one of the preceding claims, in which the digital delay means (MRT) exhibit adjustable delay values.

7. Integrated circuit according to one of the preceding claims, in which each voltage switching block comprises a chain of inverters of increasing sizes (CHTR).

8. Integrated circuit according to one of the preceding claims, in which the electronic device (PA) exhibits a differential architecture.

9. Integrated circuit according to one of the preceding claims, in which the processing pathways comprise several different sets of selectable transmission lines (LTi), the transmission lines of the various sets being respectively substantially of the quarter-wave type at different frequencies.

10. Integrated circuit according to one of the preceding claims, furthermore comprising a delta-sigma modulator (MD) coupled to a digital mixer (MX) able to deliver the said radiofrequency digital signal.

11. Emission chain for emitting a radiofrequency signal comprising an integrated circuit according to one of the preceding claims.

12. Element of a wireless communication system, for example a cellular mobile telephone, incorporating an emission chain according to Claim 11.

**Patentansprüche**

1. Integrierter Schaltkreis mit einer elektronischen Vorrichtung (PA), der Eingangseinrichtungen (BE) zum Empfang eines digitalen Funkfrequenzsignals (SCH), Ausgangseinrichtungen (BS), die ein analoges Funkfrequenzsignal (SARF) liefern können, und eine Verarbeitungsstufe enthält, die zwischen den Eingangseinrichtungen und den Ausgangseinrichtungen gekoppelt ist und mehrere parallele Verarbeitungskanäle (VTi) enthält, wobei jeder Verarbeitungskanal (VTi) einen Spannungsumschaltblock (BLCi), dessen Eingang mit den Eingangseinrichtungen gekoppelt ist, und eine Übertragungsleitung (LTi) im Wesentlichen vom Viertelwellentyp auf der Frequenz des analogen Funkfrequenzsignals enthält, die in Reihe zwischen dem Ausgang des Spannungsumschaltblocks und den Ausgangseinrichtungen gekoppelt ist, **dadurch gekennzeichnet, dass** die Verarbeitungsstufe außerdem eine neukonfigurierbare Filterstufe (FIL), die teilweise zwischen den Eingangseinrichtungen und den Spannungsumschaltblöcken gekoppelt ist und teilweise von mindestens bestimmten der Verarbeitungskanäle geformt wird, wobei die Filterstufe (FIL) digitale Verzögerungseinrichtungen (MRT) aufweist, die zwischen den Eingangseinrichtungen und mindestens einem der Spannungsumschaltblöcke gekoppelt sein können, und eine steuerbare Multiplexstufe (MUX) aufweist, die zwischen den Verzögerungseinrichtungen und den Spannungsumschaltblöcken gekoppelt ist.

2. Integrierter Schaltkreis nach Anspruch 1, bei dem die Verarbeitungskanäle (VTi) einzeln wählbar sind.

3. Integrierter Schaltkreis nach Anspruch 2, bei dem die Anzahl und die Werte der Koeffizienten des Filters (FIL) von der Anzahl der tatsächlich gewählten Verarbeitungskanäle abhängt.

4. Integrierter Schaltkreis nach einem der vorhergehenden Ansprüche, bei dem die Filterstufe eine digitale Filterstufe ist.

5. Integrierter Schaltkreis nach Anspruch 4, bei dem die digitale Filterstufe (FIL) eine digitale Filterstufe von der Art mit endlicher Impulsantwort ist.

6. Integrierter Schaltkreis nach einem der vorhergehenden Ansprüche, bei dem die digitalen Verzögerungseinrichtungen (MRT) anpassbare Verzögerungswerte haben.

7. Integrierter Schaltkreis nach einem der vorhergehenden Ansprüche, bei dem jeder Spannungsumschaltblock eine Kette von Umschaltern zunehmender Größen '(CHTR) aufweist.

8. Integrierter Schaltkreis nach einem der vorhergehenden Ansprüche, bei dem die elektronische Vorrichtung (PA) eine differentielle Architektur aufweist.

9. Integrierter Schaltkreis nach einem der vorhergehenden Ansprüche, bei dem die Verarbeitungskanäle mehrere verschiedene Sätze von wählbaren Übertragungsleitungen (LTi) aufweisen, wobei die Übertragungsleitungen der verschiedenen Sätze jeweils vom Viertelwellentyp mit unterschiedlichen Frequenzen sind.

10. Integrierter Schaltkreis nach einem der vorhergehenden Ansprüche, der außerdem einen Delta-Sigma-Modulator (MD) aufweist, der mit einem digitalen Mischer (MX) gekoppelt ist, der das digitale Funkfrequenzsignal liefern kann.

11. Sendekette eines Funkfrequenzsignals, die einen integrierten Schaltkreis nach einem der vorhergehenden Ansprüche enthält.

12. Element eines drahtlosen Kommunikationssystems, zum Beispiel eines zellularen Mobiltelefons, das eine Sendekette nach Anspruch 11 einschließt.

EP 2 266 203 B1

**FIG.1**

Conversion
numérique
analogique

Recombinaison
de puissance

PA

Sommation
analogique

VT1

BLC1

SA1

LT1

RANT

SCH

BS

BE

FPB

N voies en
parrallèle

VT2

BLC2

SA2

LT2

SARF

## FIG.2

CHTR                            $BLC_i$

| $V_{dd}$ | $V_{dd}$ | $V_{dd}$ | $V_{dd}$ | $V_{dd}$ | $V_{dd}$ | $V_{dd}$ | $V_{dd}$ |
|---|---|---|---|---|---|---|---|
| 17/1 | 47/1 | 127/1 | 340/1 | 933/1 | 2493/1 | 6800/1 | 23467/1 |
| 7/1 | 20/1 | 53/1 | 140/1 | 400/1 | 1063/1 | 2800/1 | 10267/1 |

## FIG.3

$BLC_i$

TRP$_i$

vers LT$_i$

TRN$_i$

SCH

## FIG.4

FIG.5

FIG.6

# FIG.7

## FIG.8

## FIG.9

EP 2 266 203 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• FR 0752701

**Littérature non-brevet citée dans la description**

• **FRAPPE' A.** *All-digital RF signal génération using Delta-Sigma modulation for mobile communication terminals,* 07 Décembre 2007, http://tel.ar-chives-ouvertes.fr/docs/00/28/09/68/PDF/ AFR_These_final.pdf

21